# EUROPÄISCHE PATENTSCHRIFT

(11) **EP 0 421 138 B1**
(45) Veröffentlichungstag und Bekanntmachung des Hinweises auf die Patenterteilung: **13.07.1994**
(21) Anmeldenummer: 90117100.9
(22) Anmeldetag: 05.09.1990
(51) Int. Cl.: B41F 15/46

(54) **Beschichtungsmaschine für Siebdruckgewebe**
Device for coating a screen printing tissue
Dispositif de recouvrement pour tissu pour imprimer au pochoir

(30) Priorität: 30.09.1989 DE 8911670 U
(43) Veröffentlichungstag der Anmeldung: 10.04.1991
(73) Patentinhaber: Messerschmitt, Elmar, Dr., D-81243 München (DE)
(72) Erfinder: Messerschmitt, Elmar, Dr., D-81243 München (DE)
(74) Vertreter: Riebling, Peter, Dr.-Ing.

(56) Entgegenhaltungen:
- EP-A- 0 026 538
- EP-A- 0 316 947
- WO-A-89/03258
- FR-A- 1 308 186
- US-A- 4 612 875
- US-A- 4 674 438

## Beschreibung

Die Erfindung betrifft eine Beschichtungsmaschine für Siebdruckgewebe mit an der Vorder- und Rückseite des in einem Rahmen gespannten Gewebes anliegenden Beschichtungselementen, insbesondere Rakeln und/oder Walzen.

Beim Stand der Technik liegen an der Vorder- und Rückseite des Gewebes jeweils ein einziges dieser Beschichtungselemente an. Beide Beschichtungselemente befinden sich entweder in derselben Ebene oder auch in ihrer Bewegungsrichtung gesehen hintereinander. Eine derartige Vorrichtung geht beispielsweise aus der EP-A-0 026 538 hervor.

Hieran ist es aber insbesondere nachteilig, daß mit dieser bekannten Beschichtungsmaschine nur verhältnismässig wenig Beschichtungsmasse auf das Siebdruckgewebe aufgetragen werden kann. Außerdem muß ein schlecht gespanntes Sieb zum Beschichten hierbei relativ stark verbogen werden, was zu einer Beschädigung des Siebes führen kann oder auch die Beschichtung als solche wird dadurch verschlechtert.

Die Neuerung vermeidet diese Nachteile. Ihr liegt die Aufgabe zugrunde, eine Beschichtungsmaschine mit den eingangs genannten Merkmalen vorzuschlagen, die sich insbesondere durch eine fühlbar verbesserte Beschichtung des Siebdruckgewebes auszeichnet, ohne daß dieses hierbei beschädigt werden kann.

Zur Lösung dieser Aufgabe ist die Neuerung dadurch gekennzeichnet, daß wenigstens drei der Beschichtungselemente vorgesehen sind, die in der Bewegungsrichtung der Beschichtungselemente hintereinander angeordnet sind und abwechselnd an der Vorder- bzw. Rückseite des Gewebes anliegen.

Sind nur zwei Beschichtungselemente vorhanden, so müssen diese Beschichtungselemente nacheinander stärker in das Sieb eindrücken, um eine bestimmte Spannung zu erreichen, als wenn drei oder mehr Beschichtungselemente da sind, d.h. die wellenförmige Spannung des Gewebes durch die jeweils nacheinander gegenüberliegenden Beschichtungselemente verformt das Sieb weniger stark, so daß auch Siebverzerrung und ggf. Siebbeschädigungen minimiert sind.

Bei den bisherigen Maschinen sind meist mehrfache Beschichtungsgänge nötig, um den genügenden Schichtauftrag zu erhalten. Dies beweisen die sogenannten Beschichtungsvorschriften der Nichthersteller z.B. lR/lD/lR, d.h. daß im 1. Arbeitsgang von der Rakelseite und der Druckseite her gestrichen wird und dann in einem 2. Gang wieder von der Rakelseite alleine. Bei der Beschichtung mit drei Beschichtungselementen kann ein Arbeitsgang gespart werden, denn es können zwei Beschichtungselemente auf der Rakelseite und einer auf der Druckseite beschichten.

Hierbei sieht eine erste Möglichkeit vor, daß in den Zwischenraum, den die beiden Rakel an der Vorderseite bilden, das Beschichtungsrakel an der Rückseite des Siebs eingreift. Hier ist also ein einziges Beschichtungsrakel an einer Seite des Siebes vorgesehen zwischen zwei Rakeln an der Gegenseite. Dieses kann auch ohne Kontakt mit dem Sieb mitlaufen. Der Auftrag mit Schlitz erzeugt bisher unerreichte Schichtdicken. Eine andere Lösung sieht vor, daß an den beiden parallel und im Abstand an der Vorderseite des Siebes angeordneten Rakeln zwei gleichfalls parallel und im Abstand angeordnete Rakel an der Rückseite zugeordnet sind. Diese Rakel sind jeweils auf Lücke zueinander versetzt, das heisst, die Rakel an der Vorderseite greifen genau in den Zwischenraum der Rakel auf der Rückseite ein.

Anstatt der erwähnten Rakel können auch Beschichtungswalzen, Luftrakel und dergleichen zur Beschichtung des Siebes, aber auch Luftdüsen zum Vortrocknen verwendet werden.

Die Neuerung wird im folgenden anhand von Ausführungsbeispielen näher erläutert, aus denen sich weitere wichtige Merkmale ergeben.

Die Figuren zeigen schematisch mehrere Ausführungsformen, wobei jeweils in einer Seitenansicht ein in einen Rahmen eingespanntes Siebdruckgewebe vorgesehen ist, welches mit mehreren Beschichtungselementen beschichtet wird.

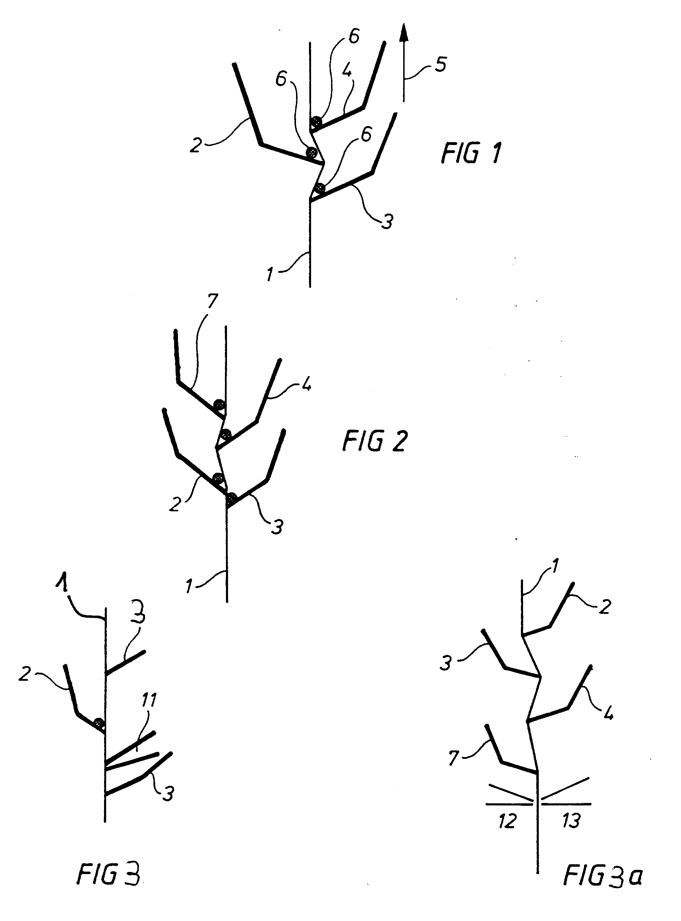

In Figur 1 ist ein Siebdruckgewebe 1 in einer Seitenansicht schematisch gezeigt, welches in einen nicht gezeigten Rahmen eingespannt ist. An der Rückseite des Gewebes liegt ein Rakel 2 an und über bzw. unter dem Rakel 2 liegen an der Vorderseite des Gewebes 1 weitere Rakel oder Beschichtungselemente 3,4 an, d.h. die Beschichtungselemente 2,3,4 sind auf Lücke angeordnet.

Zum Beschichten werden sie in Pfeilrichtung 5 nach oben oder auch in Gegenpfeilrichtung nach unten bewegt.

Jedes Rakel 2,3,4 führt eine Beschichtungsmasse 6 mit sich, um sie auf das Sieb aufzubringen.

Figur 2 zeigt eine demgegenüber abgeänderte Ausführungsform, wobei zusätzlich eine weitere Rakel 7 an der Rückseite des Siebes angeordnet ist. Auch hier sind alle Rakel auf Lücke versetzt angeordnet, wodurch die geforderte Stabilität des Siebes erreicht wird.

Die Rakel können unterschiedliche Längen haben und ihre Anstellwinkel können ggf. auch geeignet verstellt werden.

Zu Bild 3: Zeigt eine Rakel 2 auf der einen und die Rakeln 3 auf der anderen Seite und eine Luftrakel 11 dazwischen.

Bild 3a: zeigt je eine Rakel 2,3,4 und 7 abwechselnd beidseitig und 2 Trockendüsen (12 und 13) nachgeordnet.

### ZEICHNUNGS-LEGENDE

- 1: Siebgewebe
- 2: Rakel
- 3: "
- 4: "
- 5: Pfeil
- 6: Masse
- 7: Rakel
- 8: Rolle
- 9: "
- 10: Film
- 11: Luftrakel
- 12,13: Trockendüsen

## Patentansprüche

1. Beschichtungsmaschine für Siebdruckgewebe mit an der Vorder- und Rückseite des in einem Rahmen gespannten Gewebes anliegenden Beschichtungselementen, insbesondere Rakeln und/oder Walzen, die jeweils Beschichtungsmasse tragen, **dadurch gekennzeichnet**, daß wenigstens drei der Beschichtungselemente (2,3,4,7,8,9) vorgesehen sind, die in der Bewegungsrichtung (5) der Beschichtungselemente hintereinander angeordnet sind und abwechselnd an der Vorder- bzw. Rückseite des Gewebes (1) anliegen.

## Claims

1. Apparatus for coating a screen printing tissue, with coating members abutting the front and rear side of a tissue stretched in a frame, particularly doctors and/or rollers, which in each case carry coating material, characterised in that at least three coating members (2,3,4,7, 8,9) are provided, which are arranged one after another in the direction of movement (5) of the coating members and alternately abut the front and rear side of the tissue (1).

## Revendications

1. Machine d'enduction destinée à des tissus à imprimer au pochoir, comportant des éléments d'enduction, en particulier des raclettes et/ou des rouleaux, disposés sur le côté avant et le côté arrière du tissu, tendu dans un cadre et portant respectivement la substance à appliquer, caractérisée en ce qu'elle comporte au moins trois éléments d'enduction (2, 3, 4, 7, 8, 9), disposés l'un derrière l'autre dans le sens du déplacement (5) de ces éléments d'enduction et prévus en alternance sur le côté avant ou sur le côté arrière du tissu (1).
